# EUROPÄISCHE PATENTANMELDUNG

(11) **EP 0 750 452 A1**
(43) Veröffentlichungstag der Anmeldung: **27.12.1996**
(21) Anmeldenummer: 96109582.5
(22) Anmeldetag: 14.06.1996
(51) Int. Cl.: H05K 5/00

(54) **Elektronischer Lastschalter für ein Kraftfahrzeug**

(30) Priorität: 19.06.1995 DE 19522126
(71) Anmelder: Hella KG Hueck & Co., 59552 Lippstadt (DE)
(72) Erfinder: Brües, Heinrich, 59590 Geseke (DE); Lange, Petrik, Dr., 59557 Lippstadt (DE)

(57) **Zusammenfassung**

Beschrieben wird ein elektronischer Lastschalter, der einen elektronischen Leistungschalter und eine Ansteuerelektronik auf einer Hybridkeramik aufweist. Auf die Hybridkeramik sind zudem Steckerstifte direkt aufgelötet, welche ein kraftfahrzeugtypisches Steckkontaktteil ausbilden, welches anschlußkompatibel zu genormten Steckkontaktteilen elektromechanischer Lastschalter ist. Der erfindungsgemäße elektronische Lastschalter kann daher ohne weiteren Aufwand herkömmliche elektromechanische Lastschalter ersetzen.

## Beschreibung

Die Erfindung betrifft einen elektronischen Lastschalter, bestehend zumindest aus einem als Halbleiter ausgeführten elektronischen Leistungsschalter und einer integrierten Ansteuerelektronik, die beide als Schaltungsteile einer Hybridelektronik auf einer Hybridkeramik (1) angeordnet sind.

Für den zunehmenden Einsatz elektromechanischer Lastschalter (Relais) durch elektronische Lastschalter kommen Schaltungsanordnungen, bestehend aus einem elektronischen Halbleiterschalter (Transistor, Thyristor), einer Ansteuerelektronik und optional einer zusätzlichen Beschaltung mit passiven Bauelementen zur Anwendung.

Die Substitution elektromechanischer Lastschalter durch elektronische vollzieht sich dabei vorwiegend in elektronischen Steuergeräten, indem die elektromechanischen Lastschalter durch elektronische Schaltungsteile auf dem Verdrahtungsträger (z. B. der Leiterplatte) ersetzt werden.

Ein elektromechanischer Schalter im Kraftfahrzeug, der ein Steckkontaktteil und eine gekapselte Bauform aufweist, stellt eine eigenständige Baugruppe dar, die über ein entsprechendes Gegensteckkontaktteil an beliebiger Stelle im Kraftfahrzeug elektrisch und mechanisch angebunden werden kann.

Verschiedene Bauformen von eigenständigen Halbleiterrelais zeigt das Titelblatt des Prospektes "Halbleiter-Relais" 10/91, Produktübersicht; Das Programm nach Maß für alle Anwendungsbereiche" der Firma Zettler. Eine der dargestellten Bauformen zeigt Halbleiterrelais, die als bedrahtete Bauteile ausgeführt sind und auf eine Leiterplatte gelötet werden können. Bei einer anderen Bauform weist das Gehäuse des Halbleiterrelais Schraubklemmen auf, über welche das Halbleiterrelais mit elektrischen Zuleitungen verbunden werden kann.

Der Prospekt "SSR Solid State Relay; 1993, Customer Reference Brochure" der Firma Motorola zeigt einen elektronischen Lastschalter für Kraftfahrzeuganwendungen, bei dem der Lastschalter innerhalb eines relativ großvolumigen metallischen Gehäuses angeordnet ist, wobei eine flanschartig ausgestaltete Fläche des Gehäuses zur Verbindung mit einem als Wärmesenke fungierenden Metallteil (z. B. dem Motorblock), vorgesehen ist. Die elektrische Kontaktierung dieses elektronischen Lastschalters erfolgt dabei über mehrere Flachsteckverbindungen.

Bei diesen Lastschaltern nach dem Stand der Technik sind die Schaltungsteile innerhalb der Gehäuse auf elektrisch isolierenden Trägern (z. B. Leiterplatte oder Hybridkeramik) aufgebracht. Ein solcher Aufbau eines Lastschalters ist auch in den Unterlagen der Gebrauchsmusteranmeldung G 93 07 386 beschrieben.

Alle diese elektronischen Lastschalter sind aber aufgrund ihres Aufbaus nicht anschlußkompatibel zu elektromechanischen "Stand alone"-Relais (Becherrelais) und können diese daher nicht ersetzen, jedenfalls nicht ohne erheblichen zusätzlichen Aufwand (z. B. Veränderung im Kabelbaum des Kraftfahrzeuges).

Aufgabe der Erfindung ist es, einen besonders hochbelastbaren elektronischen Lastschalter so auszubilden, daß er möglichst einfach, kostengünstig und kleinbauend herstellbar ist und geeignet ist, herkömmliche elektromechanische Lastschalter unmittelbar, das heißt, ohne daß eine Änderung der äußeren Verschaltung des Lastschalters nötig wird, zu ersetzen.

Diese Aufgabe wird erfindungsgemäß dadurch gelöst, daß die Steckerstifte direkt auf die Hybridkeramik gelötet sind, so daß die Steckerstifte ein kraftfahrzeugtypisches Steckkontaktteil ausbilden, welches anschlußkompatibel zu genormten Steckkontaktteilen elektromechanischer Lastschalter ist.

In der nicht vorveröffentlichten deutschen Patentanmeldung DE 44 19 005 ist zwar bereits ein elektronischer Lastschalter beschrieben, der ein zu elektromechanischen Lastschaltern anschlußkompatibles kraftfahrzeugtypisches Steckkontaktteil aufweist.

Dieser weist aber statt einer Hybridkeramik einen metallischen Verdrahtungsträger auf, welcher auch das Steckkontaktteil ausbildet. Gegenüber dem nachfolgend beschriebenen erfindungsgemäßen Lastschalter weist dieser nicht gattungsgemäße Lastschalter eine geringere elektrische Belastbarkeit auf.

Der erfindungsgemäße elektronische Lastschalter weist eine Reihe von Vorteilen auf. So ist der erfindungsgemäße elektronische Lastschalter im Aufbau besonders einfach, da die Hybridkeramik den elektronischen Leistungschalter wie auch die Ansteuerungselektronik sowohl mechanisch trägt als auch elektrisch miteinander verbindet.

Vorteilhaft ist auch, daß die Ansteuerelektronik durchaus aus mehreren elektronischen Bauteilen bestehen kann, wobei der Verdrahtungsaufwand gering bleibt. Solche Bauelemente können nämlich besonders einfach und kostengünstig in SMD- oder gedruckter Schaltungstechnik auf der Hybridkeramik aufgebracht werden, wobei die elektrischen Verbindungen zwischen diesen Bauteilen ebenfalls auf der Hybridkeramik aufgedruckt sind.

Besonders vorteilhaft ist, daß die Kontaktstifte mittels einer Hochtemperaturlötung direkt auf die Hybridkeramik aufgelötet sind, was eine besonders einfache Montagetechnik zur Anbringung der Kontaktstifte darstellt.

Weiterhin kann hierdurch auch eine besonders gute elektrische Ankopplung der Kontaktstifte an die als Schaltungsträger fungierende Hybridkeramik erzielt werden, da die Steckerstifte recht großflächig mit der Hybridkeramik verlötet werden können, so daß die elektrischen Übergangswiderstände recht gering sind. Gleichzeitig ist damit als weiterer Vorteil auch eine sehr gute termische Kopplung zwischen Hybridkeramik und Steckerstitten gegeben.

Die Steckerstifte fungieren hierbei zunächst als Kühlkörper, indem sie die auf der Hybridkeramik anfallende Wärme zum Teil aufnehmen. Die aufgenommene Wärme leiten die Steckerstifte dann über das Gegensteckkontaktteil in den Kabelbaum des Kraftfahrzeuges.

Ein besonderer Vorteil wird auch dadurch erreicht, daß die Steckerstifte so auf die Hybridkeramik aufgelötet sind, daß sie ein kraftfahrzeugtypisches Steckkontaktteil ausbilden, welches anschlußkompatibel zu genormten Steckkontaktteilen elekromechanischer Lastschalter ist. Hierdurch können elektromechanische Lastschalter im Kraftfahrzeug ohne jeden weiteren Aufwand gegen die erfindungsgemäßen elektronischen Lastschalter ausgetauscht werden, indem der erfindungsgemäße elektronische Lastschalter in das vorhandene Gegensteckkontaktteil für den elektromechanischen Lastschalter eingesetzt wird. Der erfindungsgemäße elektronische Lastschalter arbeitet vorteilhafterweise, im Gegensatz zu elektromechanischen Lastschaltern, auch unter extremen Betriebsbedingungen vollkommen verschleißfrei.

Weitere vorteilhafte Ausgestaltungen und Weiterbildungen eines erfindungsgemäßen elektronischen Lastschalters gehen aus den Unteransprüchen hervor.

So ist es besonders vorteilhaft, den elektronischen Leistungsschalter mit einem Anschluß direkt auf einem Abschnitt eines Steckerstiftes aufzulöten. Hierdurch gelangt die am elektronischen Leistungsschalter auftretende Wärme ohne Umweg über den Hybrid direkt zum Steckerstift und wird von dort über das Gegensteckkontaktteil direkt in den Kabelbaum abgeleitet. Somit kann auf einfache Weise die Wärmeabfuhr des Lastschalters deutlich verbessert werden.

Besonders vorteilhaft ist es weiterhin, unterhalb dieses Steckerstiftes, auf welchem der elektronische Leistungsschalter aufgelötet ist, einen Temperatursensor vorzusehen, welcher die Temperatur im Bereich des Leistungsschalters sensiert und über die Ansteuerelektronik im Falle von Übertemperaturen den Leistungsschalter abschalten und so dessen Zerstörung durch Überlastung verhindern kann.

Als Temperatursensor kann hierbei vorteilhafterweise ein NTC- oder PTC-Widerstand vorgesehen werden, welcher z. B. als Dickschichtbauteil auf die Hybridkeramik aufgedruckt ist.

Hierbei kann der Temperatursensor vorteilhafterweise recht großflächig ausgeführt sein, was eine recht genaue Erfassung der Temperatur des Leistungsschalters ermöglicht. In diesem Zusammenhang ist es besonders vorteilhaft, wenn der Temperatursensor einen Abschnitt aufweist, der unterhalb des Steckerstiftes hervorragt. In diesem Abschnitt kann der Temperatursensor am fertig montierten Lastschalter leicht, z. B. mittels eines Laserstrahls kalibriert werden.

Hierdurch wird der Temperatursensor als besonders toleranzarmes Bauteil ausgeführt, wodurch die durch den Temperatursensor bewirkte Überlasttemperaturabschaltung des Leistungsschalters ebenfalls sehr genau arbeitet.

Hierdurch wiederum kann der Leistungsbereich des Leistungsschalters bis an dessen Grenze ausgenutzt werden, ohne daß eine Zerstörung des Leistungsschalters befürchtet werden muß. Somit kann der gesamte Lastschalter als besonders leistungsfähiges Bauteil ausgeführt werden.

Von besonderem Vorteil ist auch, die Hybridkeramik auf der Innenfläche eines topfförmigen metallischen Kühlkörpers aufzubringen, der zugleich das Gehäuse des elektronischen Lastschalters ausbildet. Hierdurch wird ein besonders kompakter Aufbau des Lastschalters möglich, der die Kompaktheit vergleichbarer elektromechanischer Lastschalter übertrifft.

Weiterhin kann vorteilhafterweise unterhalb eines zur Ansteuerelektronik gehörenden Halbleiters oder Chips zwischen Hybridkeramik und Kühlkörperfläche ein Hohlraum vorgesehen werden. Dieser Hohlraum wird beim Aufbringen der Hybridkeramik auf die Kühlkörperfläche mit einer schlecht wärmeleitenden Klebeschicht belegt, wodurch wirksam eine thermische Rückkopplung zwischen dem Chip oder Halbleiter der Ansteuerelektronik und dem elektronischen Leistungsschalter vermieden wird.

Durch geeignete Ausgestaltung der Ansteuerelektronik kann auf einfachste Weise der elektronische Lastschalter auch als elektronischer Blinkgeber ausgeführt werden, wobei der Leistungsschalter direkt, das heißt ohne Zwischenschaltung eines elektromechanischen Relais die Blinklampen steuert.

Im folgenden soll ein Ausführungsbeispiel eines erfindungsgemäßen elektronischen Lastschalters anhand der Zeichnung dargestellt und näher erläutert werden.

Es zeigen
- Figur 1: ein Ausführungsbeispiel eines erfindungsgemäßen Lastschalters;
- Figur 2: den in der Figur 1 gezeigten elektronischen Lastschalter in einer geschnittenen Seitenansicht;
- Figur 3: einen Teilbereich des in der Figur 1 dargestellten elektronischen Lastschalters in einer Seitenansicht und
- Figur 4: die in Figur 3 dargestellte Anordnung von der Unterseite der Hybridkeramik aus gesehen.

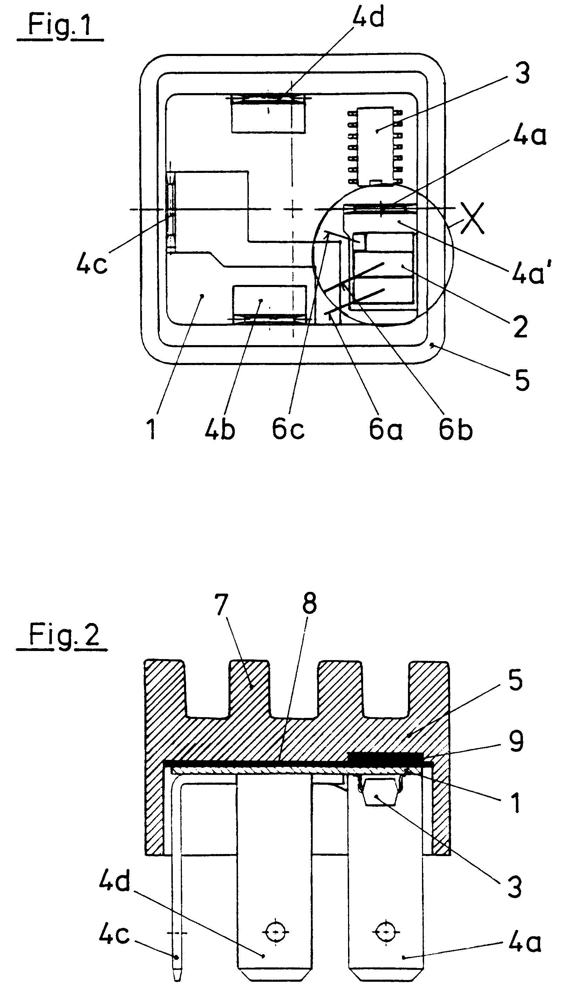

Die Figur 1 zeigt den Grundaufbau eines erfindungsgemäßen elektronischen Lastschalter auf die Hybridkeramik (1). Die Hybridkeramik (1) ist auf einer Innenfläche eines topfförmigen Kühlkörpers (5) aufgeklebt.

Zu erkennen sind vier Steckerstifte (4a, 4b, 4c, 4d) deren Endabschnitte mittels einer Hochtemperaturlötung direkt mit Lötpads auf der Hybridkeramik (1) verlötet sind.

Stellvertretend für die Ansteuerelektronik ist ein Steuerchip (3) dargestellt. Weitere Bauelemente sowie auch elektrische Verbindungen, die zur Ansteuerelektronik gehören und die in Dickschicht,- Dünnschicht- oder SMD-Technik auf der Hybridkeramik (1) angeordnet sein können, sind aus Gründen der Übersichtlichkeit nicht dargestellt.

In dem umrandeten Bereich (X) ist ein elektronischer Leistungsschalter (2) erkennbar, der auf einen abgewinkelten Abschnitt (4a') des Steckerstiftes (4a) gelötet ist.

Von einem Anschluß eines elektronischen Leistungsschalters (2) gehen zwei Verbindungsdrähte (6a, 6b) parallel geschaltet zu einem Abschnitt des Steckerstiftes (4c), während ein weiterer Verbindungsdraht (6c) zu einer nicht dargestellten Leiterbahn führt, über die der Steueranschluß des elektronischen Lastschalters (2) mit der Ansteuerelektronik (3) verbunden ist.

Zur weiteren Verdeutlichung zeigt die Figur 2 den gleichen elektronischen Lastschalter in einer geschnittenen Seitenansicht. Deutlich erkennbar sind die Hybridkeramik (1), der Steuerchip (3), drei der Steckerstifte (4a, 4c, 4d) sowie der Kühlkörper (5), dessen Oberseite zweckmäßigerweise Kühlrippen (7) aufweist.

Die Hybridkeramik (1) ist mittels einer Klebeschicht (8) auf der Innenseite des Kühlkörpers (5) aufgebracht. Hierbei ist im Bereich der Innenfläche des Kühlkörpers (5), welcher dem Anbringungsort des Steuerchips (3) gegenüberliegt, im Kühlkörper (5) ein Hohlraum (9) ausgebildet, welcher sich beim Verkleben von Hybridkeramik (1) und Kühlkörper (5) mit dem schlecht wärmeleitenden Klebstoff füllt und so den Steuerchip (3) vor einer übermäßigen Erwärmung über den Kühlkörper (5) schützt.

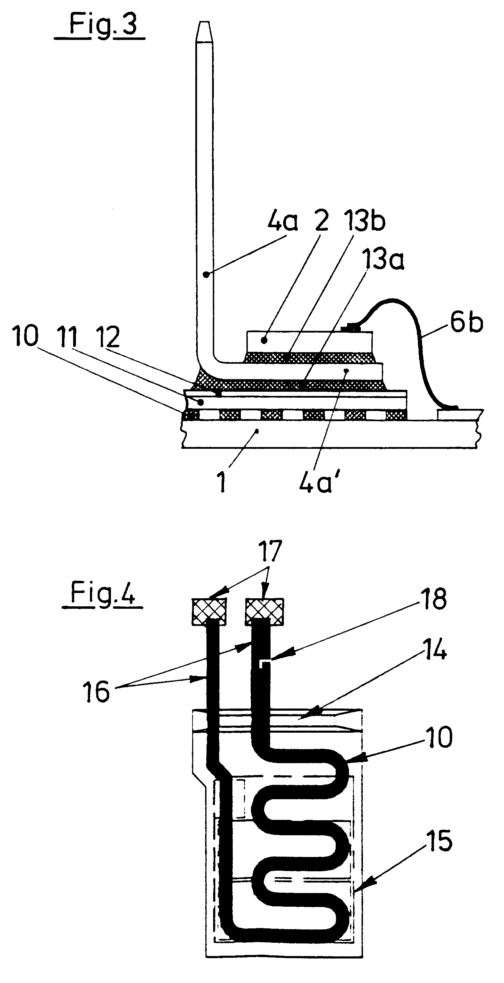

In der Figur 3 ist der in der Figur 1 mit X gekennzeichnete Bereich in einer vergrößerten Seitenansicht im Schnitt dargestellt.

Erkennbar ist der stufenartige Aufbau des Hybrids im Bereich des Steckerstiftes (4a). Auf der Hybridkeramik (1) ist zunächst in Dickschichttechnik ein NTC- oder PTC-Widerstand als Temperatursensor (10) aufgebracht.

Der Temperatursensor (10) wird durch eine Isolierschicht (11) abgedeckt, auf welcher sich wiederum ein Lötpad (12) aus Leiterbahnpaste befindet.

Auf dem Lötpad (12) ist mittels einer Hochtemperaturlotschicht (13a) (aus Su-Cu oder Su-Ag-Lot) der abgewinkelte Abschnitt (4a') des Steckerstiftes (4a) mittels einer Hochtemperaturlötung bei einer Prozeßtemperatur von ≧ 300 Grad Celsius aufgelötet. Diese Art der Lötung hat den Vorteil, daß das Lot auch bei Temperaturen von weit über 100 Grad Celsius, wie sie im Bereich des elektronischen Leistungsschalters (2) auftreten, nicht erweichen.

Die Oberseite des abgewinkelten Abschnitts (4a') ist mit einem Anschluß des elektronischen Leistungsschalters (2) großflächig mittels Hochtemperaturlötung über eine weitere Hochtemperaturlotschicht (13b) verbunden. Hierdurch wird eine besonders gute elektrische (geringer Übergangswiderstand) und termische Verbindung (gute Wärmeableitung) vom elektronischen Leistungsschalter (2) zum Steckerstift (4a) geschaffen.

Von besonderem Vorteil bei der direkten Auflötung des Leistungsschalters (2) auf dem abgewinkelten Abschnitt (4a') des Steckerstiftes (4a) ist, daß der Laststrom des elektrischen Leistungsschalters (2) nicht über vergleichsweise hochohmige Leiterbahnen auf der Hybridkeramik (1) geführt werden muß.

Die Kontaktierung der weiteren Anschlüsse des elektronischen Leistungsschalters (2) erfolgt hier über mehrere als Verbindungsdrähte vorgesehene Bonddrähte mit möglichst großem Querschnitt, wobei einer der Verbindungsdrähte (6b) in der Figur 3 dargestellt ist.

Die Figur 4 zeigt die in der Figur 3 dargestellte Anordnung von unten, das heißt aus Richtung der Hybridkeramik gesehen, wobei man sich hier allerdings die Hybridkeramik als fortgenommen oder als durchsichtig vorstellen muß. Die Mäanderstruktur stellt hierbei den Temperatursensor (10) dar, der als NTC- oder PTC-Widerstand in Dickschichttechnik ausgeführt ist.

Um den Temperatursensor (10) herum angeordneten durchgängig gezeichneten Linien deuten die Außenkontur (14) des Steckerstiftes (4a) an. Die unterbrochen gezeichneten Linien deuten die Außenkontur (15) des auf dem abgewinkelten Bereich (4a') des Steckerstiftes (4a) angeordneten Leistungsschalters an. Aus der Lage des wirksamen Bereichs des Temperatursensors (10) ist ersichtlich, daß der Temperatursensor (10), insbesondere zur Erfassung des Temperaturwertes des elektronischen Leistungsschalters vorgesehen ist.

Der Temperatursensor (10) weist Endabschnitte (16) auf, welche über Leiterbahnen (17) mit der (nicht dargestellten) Ansteuerelektronik verbunden sind. Da diese Endabschnitte (16) frei über die Hybridfläche geführt sind, können zum Toleranzabgleich des Temperatursensors, z. B. mittels eines Laserstrahls Einschnitte (18) in die Endabschnitte (16) eingebracht werden, so daß der Temperatursensor (10) ein besonders toleranzarmes Bauteil darstellt.

Der hier beschriebene elektronische Lastschalter kann insbesondere durch Veränderung in der Funktionsweise der Ansteuerelektronik leicht an andere Anwendungserfordernisse angepaßt werden. Eine solche besonders vorteilhafte Anpassung besteht z. B. darin, den elektronischen Lastschalter als vollelektronischen Blinkgeber auszubilden, der keinerlei elektromechanische Relais aufweist und der aufgrund seines gleichartig ausgebildeten Steckkontaktteiles zum Ersatz elektromechanischer Blinkgeber geeignet ist.

### Bezugszeichenliste

### Elektronischer Lastschalter für ein Kraftfahrzeug

- 1: Hybridkeramik
- 2: (elektronischer) Leistungsschalter
- 3: Ansteuerelektronik (Steuerchip)
- 4a, 4b, 4c, 4d: Steckerstifte
- 5: Kühlkörper
- 6a, 6b, 6c: Verbindungsdrähte
- 7: Kühlrippen
- 8: Klebeschicht
- 9: Hohlraum
- 10: Temperatursensor
- 11: Isolierschicht
- 12: Lötpad
- 13a, 13b: Hochtemperaturlotschicht
- 14: Außenkontur des Steckerstiftes (4a)
- 15: Außenkontur des elektronischen Leistungsschalters (2)
- 16: Endabschnitte des Temperatursensors (10)
- 17: Leiterbahnen
- 18: Einschnitt (in Endabschnitte (16))

## Patentansprüche

1. Elektronischer Lastschalter für ein Kraftfahrzeug, bestehend zumindest aus einem als Halbleiterschalter ausgeführten elektronischen Leistungsschalter (2) und einer integrierten Ansteuerelektronik (3), die beide als Schaltungsteile einer Hybridelektronik auf einer Hybridkeramik (1) angeordnet sind, dadurch gekennzeichnet, daß die Steckerstifte (4a, 4b, 4c, 4d) direkt auf die Hybridkeramik (1) gelötet sind, so daß die Steckerstifte (4a, 4b, 4c, 4d) ein kraftfahrzeugtypisches Steckkontaktteil ausbilden, welches anschlußkompatibel zu genormten Steckkontaktteilen elektromechanischer Lastschalter ist.

2. Elektronischer Lastschalter nach Anspruch 1, dadurch gekennzeichnet, daß ein Anschluß des elektronischen Leistungsschalters (2) direkt auf einen Abschnitt (4a') eines Steckerstiftes (4a) aufgelötet ist.

3. Elektronischer Lastschalter nach Anspruch 2, dadurch gekennzeichnet, daß unterhalb des Abschnittes (4a') des Steckerstiftes (4a) ein auf die Hybridkeramik (1) aufgedruckter Temperatursensor (10) angeordnet ist.

4. Elektronischer Lastschalter nach Anspruch 3, dadurch gekennzeichnet, daß der Temperatursensor (10) ein NTC- oder PTC-Widerstand ist.

5. Elektronischer Lastschalter nach Anspruch 3, dadurch gekennzeichnet, daß der Temperatursensor (10) in Dickschichttechnik ausgeführt ist.

6. Elektronischer Lastschalter nach Anspruch 3, dadurch gekennzeichnet, daß der Temperatursensor (10) möglichst großflächig ausgebildet ist.

7. Elektronischer Lastschalter nach Anspruch 3, dadurch gekennzeichnet, daß ein Endabschnitt (16) des Temperatursensors (10) die Flächenkontur des darüber gelöteten Steckerstiftes (4a) überragt.

8. Elektronischer Lastschalter nach Anspruch 3, dadurch gekennzeichnet, daß der Temperatursensor (10) bei Überschreiten eines vorgegebenen Temperaturwertes die Abschaltung des elektronischen Leistungsschalters (2) bewirkt.

9. Elektronischer Lastschalter nach Anspruch 1, dadurch gekennzeichnet, daß die Hybridkeramik (1) auf einer Innenfläche eines topfförmigen Kühlkörpers (5) aufgebracht ist.

10. Elektronischer Lastschalter nach Anspruch 9, dadurch gekennzeichnet, daß unterhalb eines zur Ansteuerelektronik (3) gehörenden Halbleiters oder Chips zwischen der Hybridkeramik (1) und der Innenfläche des Kühlkörpers (5) ein Hohlraum vorgesehen ist.

11. Elektronischer Lastschalter nach Anspruch 1, dadurch gekennzeichnet, daß in die Ansteuerelektronik (3) ein Taktgeber integriert ist, und daß der elektronische Lastschalter einen elektronischen Blinkgeber ausbildet.
